# EUROPEAN PATENT APPLICATION

(11) **EP 2 178 117 A1**
(43) Date of publication of application: **21.04.2010**
(21) Application number: 08166924.4
(22) Date of filing: 17.10.2008
(51) Int. Cl.: H01L 23/367

(54) **Power semiconductor module with double side cooling**

(71) Applicant: ABB Research Ltd., 8050 Zürich (CH)
(72) Inventor: Wildner, Franz, 5064 Wittnau (CH)
(74) Representative: ABB Patent Attorneys

(57) **Abstract**

The inventive power semiconductor module (10) comprises a heat sink (6) and an insulating substrate (2) which is in thermal contact with the heat sink (6). Further, a power semiconductor device (1) is in thermal contact over a first surface with the insulating substrate (2). A cooling member (7) establishes a thermal contact between the insulating substrate (2) and a second side of the power semiconductor device (1).

## Description

The invention relates to electronic devices and more particularly to a power semiconductor module.

Power semiconductors devices produce with their high operational voltages and / or currents so much heat that effective cooling is needed for guaranteeing an uncompromised operation of the power semiconductor device. Thus, the power density of a module depends on its capabilities to remove heat. Lowering the thermal resistance of the heat path will improve the power density of a module and will allow a higher maximum power for the same power semiconductor device.

One side of a power semiconductor device is normally soldered on an insulating ceramic substrate with metallization on both sides. This insulating ceramic substrate is mounted on a metal base plate which itself is in thermal contact with a heat sink. By the use of materials with high heat conductivity, the heat produced in the power semiconductor device can be conducted via the ceramic substrate over the metal base plate to the heat sink. The metallization of the insulating ceramic substrate, to which the power semiconductor device is soldered to, is as well used as a lead for a first terminal of the power semiconductor device. On the other side of known power semiconductor devices, metal wires connect another terminal or further terminals of the power semiconductor device with the other lead or leads of the power semiconductor module.

Thus, the side of the power semiconductor device connected by metal wires does not conduct operational heat and cannot be used for cooling the power semiconductor device. Therefore, the United States Patent US 7,005,734 B2 proposes to cool the power semiconductor device on both sides by leading the heat on each side to a corresponding heat-sink.

This has the disadvantage that an additional heat-sink is needed what rises the production costs and needs more space. Further, the additional heat sink causes a high production-complexity for connecting the terminals of the power semiconductor with the leads.

The object of the present invention is to improve the cooling of the state of the art and to avoid the beforementioned disadvantages. The inventive power semiconductor module comprises a heat sink and an insulating substrate which is in thermal contact with the heat sink. Further, a power semiconductor device is in thermal contact over a first surface with the insulating substrate. A cooling member establishes a thermal contact between the insulating substrate and a second side of the power semiconductor device.

Thus, the heat can be transported from the second side of the power semiconductor device via the cooling member, the insulating substrate and finally, to the heat sink. Therefore, only one heat sink is needed, what saves space and production costs.

The dependant claims relate to further advantageous aspects of the invention.

According to the invention, the insulating substrate has a first metallization on a first side and a second metallization on a second side.

According to the invention, it is advantageous that the second metallization on the second side of the insulating substrate comprises at least one first and second metallization part, which form a number of conductors each connected with its corresponding electrical terminal of the power semiconductor device. This allows even electric contact to the electronic device via the cooling member if made from electric conductive material.

According to the invention, it is advantageous that the second metallization on the second side of the insulating substrate has at least a first and a second conductor which are not in conductive contact. The first conductor is connected to an electrical terminal on the first side of the power semiconductor device and the second conductor is in contact with the cooling member which is electric conductive and in contact with an electric terminal on the second side of the power semiconductor device. Thus, the metal wires for connecting the conductors on the insulating substrate with the terminal on the second side of the power semiconductor device become indispensable. This saves costs, simplifies the construction and the cooling member is much more robust than any metal wire.

According to the invention, a power semiconductor module comprises a plurality of power semiconductor devices and the one cooling member is in thermal contact with each power semiconductor device. Thus, one cooling member can cool several power semiconductor devices and support them with electricity.

### Brief description of the drawings:

- Fig. 1: sectional drawing of the power semiconductor module according to the invention;
- Fig. 2: three-dimensional view of the power semiconductor module without the cooling member and the removed cooling member according to the invention.

Common power semiconductor devices are power diode, thyristor, power metal oxide semiconductor field-effect transistor (MOSFET) and insulated gate bipolar transistor (IGBT). A power semiconductor device comprises the die, which is integrated in a mold resin member. Terminals on the power semiconductor device connect the different semiconductor materials with electrical leads of a circuit. The power semiconductor device is packaged to a power semiconductor module as presented in the following.

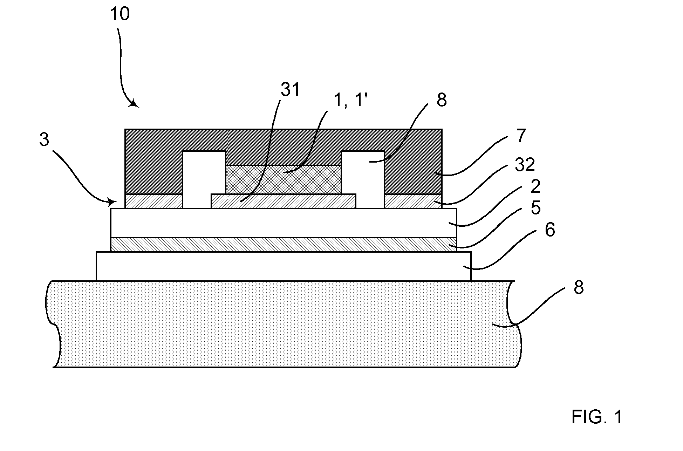

Fig. 1 shows a sectional drawing of the power semiconductor module 10. An IGBT 1' as a power semiconductor device 1 is soldered with a first side on a second side of an insulating substrate 2 which has a metallization layer 3 and 5 on both sides. The second metallization 3 comprises at least one first metallization part 31 and at least one second metallization part 32. The insulating substrate 2 is an electrically insulating substrate typically made of ceramic. In the following, the metallization 5 on the first side of the insulating substrate 2 is called first metallization 5 and the metallization parts 31 and 32 together on the second side are called second metallization 3. The first side of IGBT 1' that serves as an example in the illustrated embodiment and the second metallization 3 are soldered with their surfaces to each other such that the touching surface of the IGBT 1' and the first metallization part 31 is maximized and conducts as much heat as possible. The device is not soldered by only an angular connection but by the plane surface. The same applies for all other solder connections described according to the present invention.

The insulating substrate 2 is soldered over the first metallization 5 to a thermally conductive base plate 6, typically made of metal. The base plate 6 is mounted on a heat sink 8 so that the operational heat produced by the IGBT 1' can be transferred to the heat sink 8 because the IGBT 1', the insulating ceramic substrate 2, the metal base plate 6 and the heat sink 8 are thermally connected. The heat sink 8 can be water or air streamed cooling element.

The second metallization 3 with first and second metallization parts 31 and 32 of the insulating substrate 2 shows different conductors or leads which are part of the electronic circuitry. The IGBT 1' is soldered with its first side on the first metallization part 31 that fixes the IGBT 1' and the first conductor connects for example collector terminal on the first side of the IGBT 1' with the first metallization part 31. A cooling member 7 made advantageously of copper is soldered to the second metallization part 32 on both sides of the first conductor. Alternatively, the cooling member 7 is soldered to the second metallization part 32 at least on one side of the first metallization part 31. The cooling member 7 is formed as a bridge and soldered as well to the second side of the IGBT 1'. Thus, the operational heat of the IGBT 1' can be transferred even from the second side of the IGBT 1', which is arranged opposite the first side, over the cooling member 7 to the insulating substrate 2 and thus, again to the heat sink 8. The cooling member 7 is soldered over the second metallization part 32 on both sides of the IGBT 1' to the insulating substrate 2 for transporting effectively the heat to the insulating substrate 2. The cooling member 7 is directly attached to the second side of the IGBT 1' and to the second metallization part 32.

In addition, the cooling member 7 made of copper connects the second metallization part 32 for example with the emitter terminal on the second side of the IGBT 1'. The terminals of the IGBT 1' are not explicitly shown in Fig.
1. The conductor for the gate of the IGBT 1' is as well not shown in Fig. 1, since it is not relevant for the invention. A further metallization part may be located between metallization parts 31 and 32 for electric connection to gate of the IGBT 1' which is performed by conventional techniques as bonding for example.

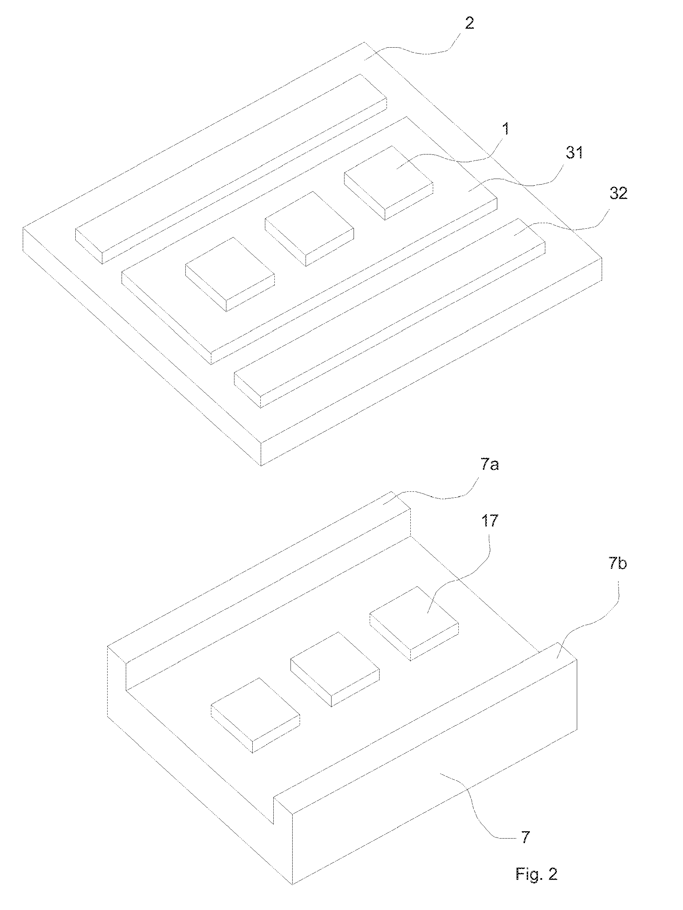

Fig. 2 shows a schematic three-dimensional view of the insulating substrate 2 with metallization parts 31 and 32 and several IGBTs 1 mounted or soldered thereon. The cooling member 7 is shown in a demounted state such that the construction of the power semiconductor module 10 can be understood better. The cooling member 7 is soldered on the second metallization part 32 on both lateral sides of the IGBTs 1 and soldered on the second side of the IGBT 1', the emitter terminal, such that a connection in parallel is realised. Thus, only one cooling member 7 is needed to cool several IGBTs 1 and to connect their emitter terminals. For contacting a plurality of lined up devices, the cooling member 7 is basically U-shaped with a number of contact platforms 17 between the arms 7a, 7b of cooling member 7. The shape of platforms 17 corresponds to the shape of the respective terminal of IGBT 1'.

All connections in this patent established by soldering do not limit the invention. Alternatively, the relevant parts can also be mounted or fixed in a different way such as clamping or any bonding method, e.g. low temperature bonding, typically with silver, whereas bonding is used in this application as a general term for any such connections. Further, the invention is not restricted to a copper cooling member 7. The cooling member 7 can be made of all elements with a high heat conductivity such as copper, silver, molybdenum, tungsten and their alloys.

## Claims

1. A power semiconductor module (10) comprising:
- a heat sink (8);
- an insulating substrate (2) being in thermal contact with the heat sink (8);
- a power semiconductor device (1) having a first and second side, whereby the first side of the power semiconductor device (1) is in thermal contact the insulating substrate (2);
**characterized by**
- a cooling member (7) being in thermal contact with the insulating substrate (2) and with the second side of the power semiconductor device (1).

2. Power semiconductor module (10) according to claim 1, further comprising a thermally conductive base plate (6) being in thermal contact with the insulating substrate (2) and the heat sink (8) for conducting heat from the insulating substrate (2) over the base plate (6) to the heat sink (8).

3. Power semiconductor module (10) according to any of claims 1 and 2,
wherein the insulating substrate (2) has a first metallization (5) on a first side and a second metallization (3) on a second side.

4. Power semiconductor module (10) according to claim 3,
wherein the first metallization (5) of the insulating substrate (2) is bonded to the base plate (6).

5. Power semiconductor module (10) according to any of claim 3 and 4, Wherein the second metallization (3) comprises at least a first metallization part (31) and at least one second metallization part (32).

6. Power semiconductor module (10) according to claim 5,
wherein the first side of the power semiconductor device
(1) is bonded to the first metallization part (31) of the insulating substrate (2).

7. Power semiconductor module (10) according to any of claims 5 or 6,
wherein the cooling member (7) has thermal contact with the at least one second metallization part (32) of the insulating substrate (2).

8. Power semiconductor module (10) according to claim 7,
wherein the at least one first and/or second metallization parts (31, 32) on the second side of the insulating substrate (2) forms a number of conductors each connected with its corresponding electrical terminal of the power semiconductor device (1).

9. Power semiconductor module (10) according to claim 8,
wherein the at least one first and/or second metallization parts (31, 32) on the second side of the insulating substrate (2) has at least a first conductor and a second conductor which are not in conductive contact.

10. Power semiconductor module (10) according to claim 9,
wherein the first conductor is connected to an electrical terminal on the first side of the power semiconductor device (1) and the second conductor is in contact with the cooling member (7), which is electrically conductive and which is in contact with an electric terminal on the second side of the power semiconductor device (1).

11. Power semiconductor module (10) according to any of claims 1 to 10,
wherein the cooling member (7) is made of metal or a metal alloy with high heat conductance and / or high electrical conductivity.

12. Power semiconductor module (10) according to claim 11,
wherein the cooling member (7) is made of copper, silver, molybdenum, tungsten or their alloys.

13. Power semiconductor module (10) according to any of claims 1 to 12,
wherein the cooling member (7) is bonded in form of soldering, low temperature bonding or clamping to the insulating substrate (2) and / or to the power semiconductor device (1).

14. Power semiconductor module (10) according to any of claims 1 to 13,
wherein the power semiconductor module (10) comprises several power semiconductor devices (1) and one cooling member (7) is in thermal contact with each power semiconductor device (1).
